Europäisches Patentamt

European Patent Office

Office européen des brevets

(19)

(11) Publication number: **0 097 158**

**B1**

(12)     EUROPEAN PATENT SPECIFICATION

(45) Date of publication of patent specification: **08.02.89**

(51) Int. Cl.⁴: **G 06 F 11/10**

(21) Application number: **82900590.9**

(22) Date of filing: **30.12.81**

(86) International application number:
**PCT/US81/01766**

(87) International publication number:
**WO 83/02344 07.07.83 Gazette 83/16**

(54) INFORMATION SYSTEM USING ERROR SYNDROME FOR SPECIAL CONTROL.

(43) Date of publication of application:
**04.01.84 Bulletin 84/01**

(45) Publication of the grant of the patent:
**08.02.89 Bulletin 89/06**

(84) Designated Contracting States:
**DE FR GB**

(56) References cited:
**FR-A-2 325 148**
**US-A-3 471 830**
**US-A-3 571 794**
**US-A-3 701 019**
**US-A-3 836 957**
**US-A-3 872 430**
**US-A-4 142 174**
**US-A-4 168 486**
**US-A-4 241 446**
**US-A-4 261 054**

**IBM TECHNICAL DISCLOSURE BULLETIN, vol. 13, no. 1, June 1970, pages 207-208, New York, US; P. HODGES et al.: "Virtual memory method for flagging recorded information"**

(73) Proprietor: **International Business Machines Corporation**
**Old Orchard Road**
**Armonk, N.Y. 10504 (US)**

(72) Inventor: **MELTZER, David**
**68 Maloney Road**
**Wappingers Falls, NY 12590 (US)**

(74) Representative: **Barth, Carl Otto et al**
**IBM Deutschland GmbH Patentabteilung**
**Schönaicher Strasse 220**
**D-7030 Böblingen (DE)**

Courier Press, Leamington Spa, England.

## Description

### Background of the Invention
### Field of the Invention

This invention relates to a data processing system in accordance with the preamble of claim 1 and to a method of controlling data flow in such a system. More particularly, the invention relates to incorporating special flag and/or status indicating code signals at random positions in serially ordered data without utilizing bit combinations which might otherwise normally be used to represent valid data.

### Prior Art

There can be many situations in which it becomes desirable to include "flags" in fields of data that are utilized by an information processing system. These fields may be contained in a storage medium associated with the information processing system, or may be transmitted to the system via some communication link. For example, such flags could be used to provide synchronization of various kinds, to define the limits of variable length data messages, and to indicate the limits of storage fields assigned to various users in a multiprogramming system.

The typical straightforward approach to filling such a need is to allocate a particular combination of data bits to represent the desired flag. The disadvantage of this approach is that the number of bit combinations which can represent valid data are reduced if some of those combinations must be utilized to represent control flags.

Another approach to the problem is exemplified by U.S. patent 3,913,068 which describes a system in which data employed for synchronization purposes is arranged in a different code than data which represents information. With the instant invention, special symbols (flags) are coded in the same form as other data thereby conserving code utilization and bandwidth, as well as simplifying the system.

Other prior art of particular interest includes two articles appearing in the IBM Technical Disclosure Bulletin, Vol. 20, No. 9, February 1978, pages 3579—3580 and 3585—3586. These items of prior art are of interest because they deal with responses by a system to syndromes which indicate the presence of a data error. However, they do not suggest utilizing error syndromes for purposes other than error handling. One manner in which the instant invention distinguishes significantly over such prior art is in utilization of predetermined data configurations and error syndromes for special system control.

The simple use of unique error syndromes to generate system control signals has been proposed in US—A—3,836,957 "Data Storage System with Deferred Error Detection". Prior to storing data in a memory unique error syndromes are concatenated with data bits in which a parity error has occurred; upon retrieval of these data bits out of the memory the unique error syndrome is recognized to generate a flag signal that inhibits the ECC means from issuing an error signal before the data is passed to the processor. This system is, however, limited in its flexibility as the restricted number of usable unique codes cannot provide arbitrary flags for general use in the system.

### Brief Description of the Invention

In accordance with a preferred embodiment of the invention, special characters are represented by predetermined combinations of data bits and error correcting code (ECC) redundancy bits. These predetermined combinations are selected from among the combinations which normally occur only when an uncorrectable error has occurred in a word. These predetermined patterns are decoded by the system as the special characters or flags. In the preferred embodiment, when a flag is recognized, no error indication will be transmitted to the using system.

The primary commercial advantages achieved with this invention are:

it does not impact the amount of information that can be represented within the information system (because the combinations utilized for the flags would otherwise have no valid meaning);

the invention does not degrade the normal error detection and correction capability of the system; and

it is simple and inexpensive to implement.

### Brief Description of the Drawings

Figure 1 is a simplified block diagram of the invention as it would be incorporated into a typical information handling system.

Figure 2 provides more details of an embodiment of the invention which can be used to detect a single special character.

Figure 3 is an alternative embodiment of the invention similar to the one shown in Figure 2, but which allows the determination of a multiplicity of different special characters within the same computer system.

### Detailed Description

The following descriptions of embodiments of the invention show how it can be incorporated into a typical information handling system. Aspects of such systems such as, for example, single error correction and specific detailed timing considerations, upon which this invention has little or no impact are not described in detail below. Those aspects will vary from system to system and are quite well known to those of ordinary skill in the art. Rather, the following discussion will concentrate on portions of the system that are affected by this invention.

In accordance with this invention, groups of bits representing data and associated ECC (error correction code) functions — each group representing a number element in a double error detecting single error correcting code system — are monitored for the presence of a predetermined syndrome, one normally associated with uncorrectable error (UE) conditions, and for the coincident presence in the data portion of each group of a predetermined data pattern, one normally (in the absence of a UE condition) representing ordinary data. When the predetermined syndrome is detected in conjunction with the predetermined data pattern, a flagging or delimiting condition is recognized, an associated indication is presented to control circuits of the system responsible for processing the data, and the UE condition normally associated with the predetermined syndrome is suppressed. If the predetermined error syndrome is detected but the predetermined data pattern is not found, the associated UE condition is not suppressed, and an error indication is passed on to control circuits of the system responsible for attending to error conditions.

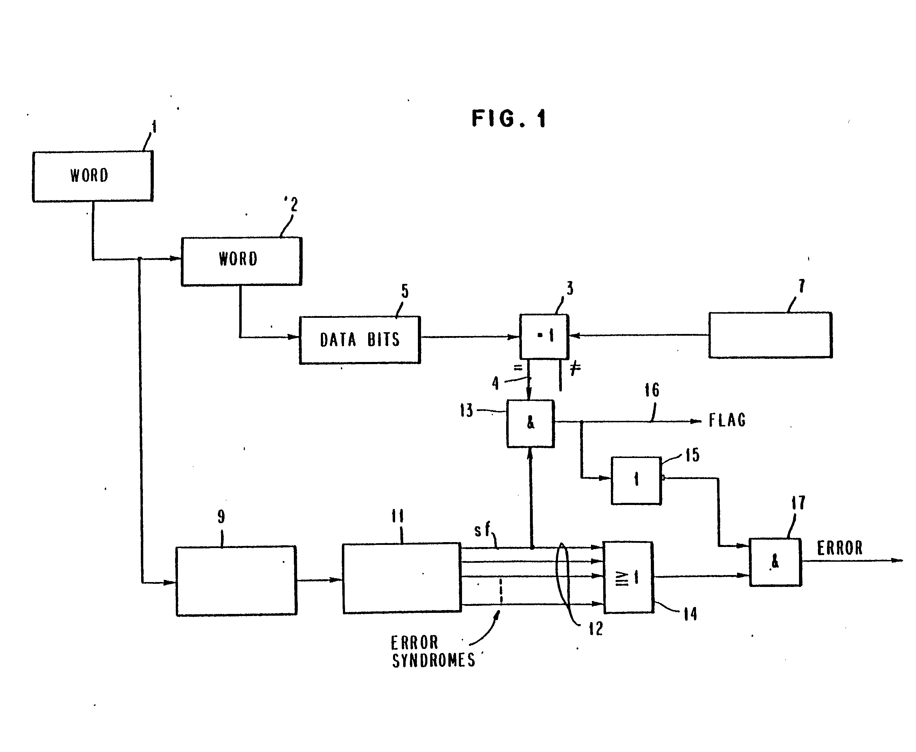

A simple block diagram of the invention is shown in Figure 1. An exemplary code structure of 72 bits is assumed; 64 data bits and 8 ECC bits. Each word received from a storage medium or communication link 1 is staged in a 72-bit wide shift register 2, and concurrently applied to syndrome generating circuits 9. Each group of 64 data and 8 ECC bits gives rise to an associated group of 8 syndrome bits. Each group of syndrome bits is applied to syndrome decoding circuits 11 which activate an associated one of up to 256 (i.e. $2^8$) output lines. A subset 12 of these output lines are associated with uncorrectable error (UE) conditions and are coupled via OR circuit 14 to AND circuit 17. One particular line "sf" in this subset, which can be associated with either a flag signal combination or a true EU condition, is connected to AND circuit 13. The 64 data bits from the word in register 2 are put in register 5 which feeds one input of a comparator circuit 3 which receives its other input from a reference 7 which contains the predetermined pattern of data bits.

If the data bits in register 5 match the reference bits in register 7, comparator 3 will produce an output on line 4 which feeds one input of AND 13. The second input of AND 13 is fed by syndrome line "sf" which will be up if the predetermined syndrome was generated by syndrome generator 9 and decoded by syndrome decoder 11. The concurrence of the predetermined syndrome and the predetermined data pattern will enable AND 13 which will present, via line 16, a signal to the information processing system that the particular flag has been detected. When the flag has been detected, the enabled output of AND 13 will, by acting through inverter 15, disable AND 17, thereby preventing an error indication from being transmitted to the information processing system.

If the predetermined syndrome sf does not appear, the results of the comparison between register 5 and reference medium 7 will not affect the system. Similarly, if the contents of register 5 do not match the reference contained in medium 7, AND 13 will not be enabled and if syndrome sf (or any other error syndrome) were to appear, it would be transmitted to the information processing system through OR 14 and AND 17 to signal the occurrence of an error.

The simplicity of this invention can be appreciated by noting that most of the elements shown in Figure 1 would already be present in a typical information processing system. In addition to modification of the source 1, the elements added by this invention would be comparator 3, data register 5 (which would already be present in some systems), reference medium 7, AND 13 and inverter 15. All of the remaining elements would typically already be present in any information processing system utilizing a single error correction double error detection code.

With appropriate selection of the data and ECC flag combination, it is possible to adapt such systems to recognize the flag combination even when it contains a single bit error. In such circumstances a data match in conjunction with a generated single error syndrome having unit code value distance from "sf" is recognized as a flag. Also, a data mismatch in conjunction with a syndrome having unit distance from "sf" would activate error correction circuits to apply a single error correction to the data, which in turn would give rise to generation of data and syndrome "sf" (i.e. the flag recognition), or to another combination representing a true UE.

This invention may also be used to embed distinguishing indications in storage areas of a data processing system without dedicating storage space exclusively for this purpose. For instance, the PL/I checkout compiler (refer to "PL/I LANGUAGE REFERENCE MANUAL" publication number GC 33-009, available through IBM sales representatives and branch offices) requires a capability of distinguishing between initialized and uninitialized storage variables. In accordance with the present invention this capability can be achieved simply by storing a special "nominally illegal" pattern of data and ECC bits to signify uninitialized status in the associated area. Upon removal from storage the data is compared to a reference pattern while the data and associated ECC bits are being monitored by the conventional error detection and correction circuitry associated with storage access. If the output data matches the reference pattern and there is detection of a particular UE syndrome the associated UE condition is masked or inhibited and a program interruption is generated. With this interruption the uninitialized condition of the just-addressed storage area can be effectively communicated to programs responsible for supervising "normal" PL/I operations.

In the above discussion, and in the discussions to follow, no detailed description is provided as to the manner in which source 1 produces the predetermined data pattern and concatenates to it appropriate ECC bits so that the predetermined syndrome will be generated when the word is received. A variety of techniques such as, for example, microinstruction sequences which are triggered by software instructions, are well known to those skilled in the art. Some techniques are suggested in the prior art discussed above. The only significant requirement is that the source 1 (which, of course, could be part of the same information processing system which is utilizing the data) be able to generate the predetermined unique combination of data bits and ECC bits. This generally will require that the source be able to at least partially disable or ignore its own error detection and correction circuitry.

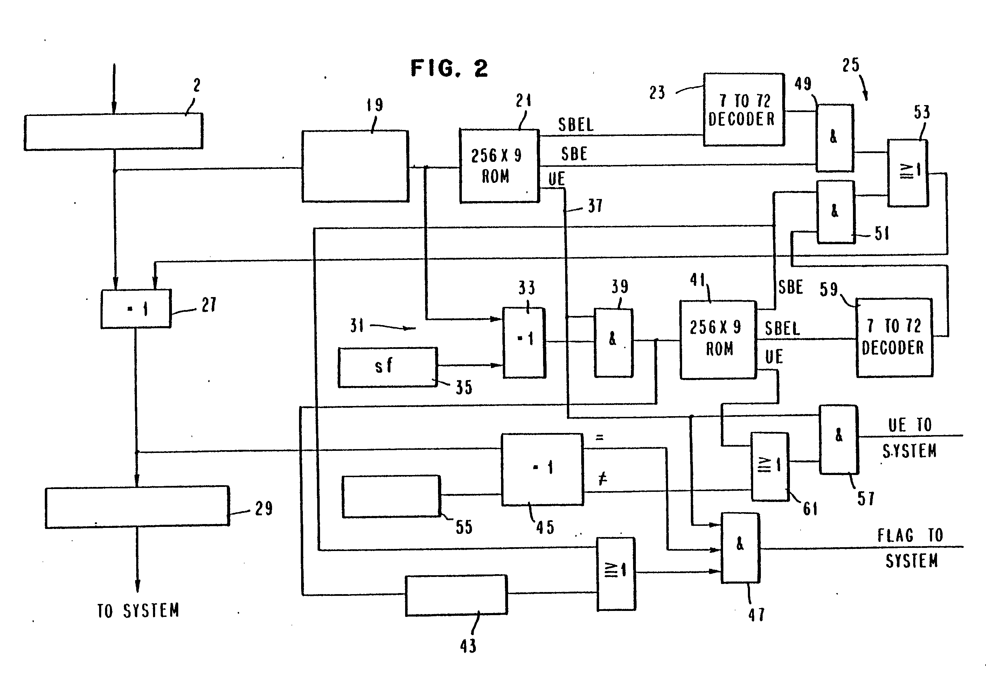

Referring now to Figure 2, additional details are shown of a preferred embodiment of the invention. 72-bit word combinations of data and check bits, from a storage medium or communication link are latched (preferably in bit-parallel form) into register 2. Standard checking apparatus with correction capability (including syndrome generator 19, syndrome lookup read only memory ROM 21, error locator decoder 23, error steering gates 25 and corrector Exclusive ORs 27) corrects any single bit error present in the data and latches the corrected data into register 29. Register 29 presents the corrected data at its output to the processing system.

If the syndrome indicated by ROM 19 is one which normally represents an uncorrectable error UE (two or more bit errors in a single word), circuitry 31 for recognition of a special control flag condition is utilized. The bits of the 8-bit syndrome generated by syndrome generator 19 are fed to Exclusive-ORs 33. Exclusive-ORs 33 also receive a reference 8-bit syndrome stored in an appropriate medium 35. If the syndrome decoder ROM 21 detects a syndrome representative of an uncorrectable error, line 37 will enable AND 39 so the Exclusive-OR of sf with the output of syndrome generator 19 will be passed to table lookup ROM 41 for translation. In the preferred embodiment, ROM 41 is identical to ROM 21. This provides some error correction capability with respect to the special flag. Two cases can be indicated at the output of ROM 41: an uncorrectable error UE; or a single bit error SBE. When a SBE is indicated there will also be a 7-bit code SBEL uniquely defining the bit location of the single bit error.

The concurrence of a UE signal on line 37 and all zeros at the output of AND 39 (as recognized by zero detector 43) enables AND 47 to signal the occurrence of a special "no-error" condition associated with the flag syndrome sf. This indicates that a flag syndrome has been detected. In this situation, neither of ANDs 49 or 51 will have been enabled, so there will be no output from OR 53. Therefore, Exclusive-ORs 27 will pass the contents of register 2 unchanged. If the value of the data portion of the contents of register 2 equals the predetermined data bit pattern held in medium 55, the output of comparator 45 will furnish the third input necessary to enable AND 47 to indicate of a flag. This flag is then indicated to the using system, for example, by signalling a program interrupt to the processor using the storage device. In addition, since the comparator 45 indicates that the data bit pattern was equal to the reference pattern, AND 57 will not he enabled and no UE indication is given to the system.

If the output of AND circuits 39 indicate a non-zero syndrome, the modified syndrome is used as an address into ROM 41 to determine if the syndrome represents a single bit error. If it does, by the activation of the SBE bit output, the error locator field (SBEL) of the ROM is gated to a one-of 72 (7 bit to 72 decoder) decoder 59. The output of decoder 59 is presented to Exclusive ORs 27 via AND/OR 51, 53 to correct the single bit error. The corrected data is then presented to the comparator 45 whose output is interpreted as described above.

If the output of ROM 41 indicates that the modified syndrome still indicates a UE, the UE output of the ROM goes through OR 61 to AND 57 to indicate a UE to the system.

Because ROM 21 is identical to ROM 41, and decoder 23 is identical to decoder 59, a design could be employed which time-shares these parts to reduce cost. However, in such an embodiment, recognition of a flag would take longer than in the implementation shown.

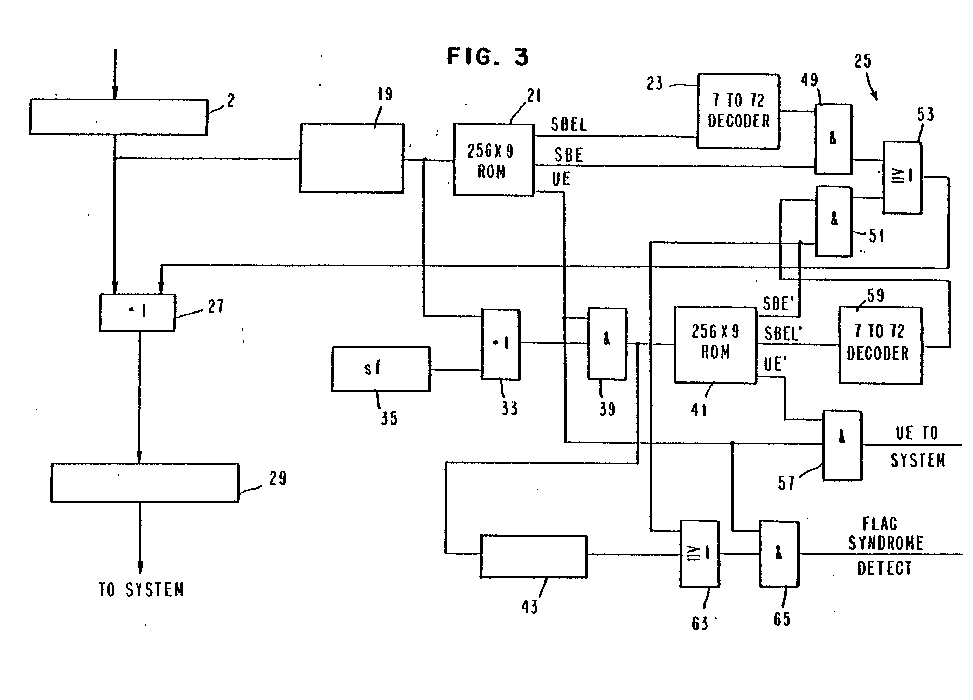

Figure 3 shows an alternative embodiment which is similar to the one shown in Figure 2, but which allows the determination of a multiplicity of different flag patterns within the same computer system. The embodiment of Figure 3 would allow, for instance, storage of different flag data word symbols for different users, so that each user could prevent other users from having access to data deliniated by his flag symbol.

In this embodiment, as in the previous embodiment, the syndrome derived from the currently manifested word is examined for association with either good data, a single bit error or an uncorrectable error (UE). If a UE syndrome is detected by ROM 21, that syndrome is Exclusive ORed with the flag syndrome sf in Exclusive ORs 33 and then further decoded to show either a zero (indicating a flag syndrome without an error), a single bit error (SBE) or an uncorrectable error (UE) as before. An indication of no error or a single bit error (with the location of the single bit error indicated by the output of error locator 59) results in correct data going to the system processing circuits via register 29 without any flag or UE error indication. If ROM 21 indicates a UE and a flag is not detected, AND circuits 57 indicate an uncorrectable error to the using information processor. If ROM 21 indicates a UE and a flag syndrome, with or without a single bit error, is detected, OR 63 will enable AND 65 to indicate a flag symbol detection to the using processor. The associated data word will be presented to the processor in register 29.

By appropriate programming, each processor could reference a table of data patterns (for example, one pattern corresponding to each user program for which following data words are to be presented). The value manifested in register 29 could then be compared by each processor to the value in the table, for extraction of an associated flag. If no match is detected, the processor would recognize that either the data contains an uncorrectable error or it represents another user's flag. There is no way to determine which of these situations actually occurred. However, in either case the processor examining the data would be able to determine that the data has no validity for that processor.

Those skilled in the art will recognize that various changes can be made in the embodiments described above. For example, words of any desired length may be used instead of the 72 bit words discussed above. Also, any desired linear error detection code may be used. It is preferred that the code have at least single error correction capability, but this invention could be implemented in a system having single error detection without error correction. However, this is not preferred because such an implementation would tend to be a little less reliable than an implementation with error correction capability. Of course, the invention is quite suitable to use in systems with higher error correction capabilities.

## Claims

1. Data processing system with error checking and correcting (ECC) means (9, 11) using error syndromes for combinations of data bits and EEC checkbits and generating system control signals (FLAG) upon the occurrence of predetermined syndromes (sf) for uncorrectable errors characterized in that the system comprises:
first means (3) to detect at least one predetermined pattern in the data bits
second means (13) to detect as a system control signal (FLAG) the coincident presence of the predetermined data pattern and the occurrence of at least one of the predetermined uncorrectable error syndromes (sf) and
means (15) to inhibit the EEC means from issuing an error signal in case of said coincidence.

2. The system of claim 1 further comprising first means (21, 23, 25, 27) to correct single bit errors before the data bits are supplied to the first detection means.

3. The system of claim 1 or 2 wherein means (33) are provided to logically combine the error syndrome of the data bits with the predetermined error syndrome read from a storage means (35) for actuating second means (41, 59) to correct single bit errors in case of a uncorrectable error signal (UE) issued by the first means to correct single bit errors.

4. The system of one of the claims 1—3 wherein storage means (55) are provided for the predetermined data pattern, the output of which is connected to compare means (45) also receiving the data bits corrected for single bit errors.

5. The system of one of the claims 1—4 wherein the combination of the predetermined data pattern and the predetermined error syndrome represents a boundary delimiting flag in the stream of data and EEC bits, which is indicated by the system control signal.

6. A method for controlling data flow in a data processing system which provides for error checking and correcting (ECC) by using error syndromes (12) for combinations of data bits and (EEC) checkbits and wherein predetermined syndromes (sf) of uncorrectable errors are used to generate system control signals (FLAG) characterized in that the method comprises the steps:
detecting at least one predetermined pattern in the data bits,
detecting as a system control signal (FLAG) the coincidence of the predetermined data pattern with the predetermined uncorrectable error syndrome (sf) and,
inhibiting, in case of coincidence, the uncorrectable error condition signal.

7. The method of claim 6 wherein the predetermined data pattern is detected after single bit error correction has been performed.

8. The method of claim 6 or 7 wherein the system control signal indicates a flag condition in the data stream.

## Patentansprüche

1. Datenverarbeitungssystem mit Fehlerprüf- und Fehlerkorrektur (ECC)-Vorrichtung (9, 11), welches Fehlersyndrome für Kombinationen aus Datenbits und EEC-Prüfbits benützt und Systemsteuersignale (FLAG) beim Auftreten vorbestimmter Syndrome (sf) für nicht korrigierbare Fehler erzeugt, dadurch gekennzeichnet, daß das System folgendes enthält:
erste Mittel (3) zum Erkennen mindestens eines vor-bestimmten Musters in den Datenbits
zweite Mittel (13), um als ein Systemsteuersignal (FLAG) die zeitliche Koinzidenz des vor-bestimmten Datenmusters mit mindestens einem der vor-bestimmten nicht korrigierbaren Fehlersyndrome (sf) festzustellen, und
Mittel (15), um im Fall einer solchen Koinzidenz die Abgabe eines Fehlersignals durch die EEC-Vorrichtung zu verhindern.

2. System nach Anspruch 1, welches außerdem erste Vorrichtungen (21, 23, 25, 27) zur Korrektur von Einzel-Bitfehlern vor der Abgabe der Datenbits an die ersten Erkennungsmittel enthält.

3. System nach Anspruch 1 oder 2, bei dem Mittel (33) zum logischen Verknüpfen der Fehlersyndrome der Datenbits mit dem vor-bestimmten Fehlersyndrom vorgesehen sind, welches aus einem Speicher (35) gelesen wurde, um zweite Vorrichtungen (41, 59) zu aktivieren und Einzel-Bitfehler im Falle eines nicht korrigierbaren Fehlersignals (UE) zu korrigieren, welches von der ersten Vorrichtung zur Korrektur von Einzel-Bitfehlern abgegeben wurde.

4. System nach einem der Ansprüche 1—3, bei dem ein Speicher (55) für das vor-bestimmte Datenmuster vorgesehen ist, dessen Ausgang mit einer Vergleichsvorrichtung (45) verbunden ist, welche ebenfalls die bezüglich Einzel-Bitfehlern korrigierten Datenbits empfängt.

5. System nach einem der Ansprüche 1—4, bei dem die Kombination des vor-bestimmten Datenmusters mit dem vor-bestimmten Fehlersyndrom eine Begrenzungsmarkierung im Strom der Daten- und EEC-Bits darstellt, die durch das Systemsteuersignal angezeigt wird.

6. Verfahren zum Steuern des Datenstroms in einem Datenverarbeitungssystem, bei welchem Fehlerprüfung und -korrektur (ECC) dadurch ausgeführt werden, daß Fehlersyndrome (12) für Kombinationen aus Datenbits und (EEC)-Prüfbits, sowie vorbestimmte Syndrome (sf) nicht korrigierbarer Fehler zum Erzeugen von Systemsteuersignalen (FLAG) verwendet werden,
dadurch gekennzeichnet, daß das Verfahren folgende Schritte umfasst:

Erkennen mindestens eines bestimmten Musters in den Datenbits,

Erkennen der zeitlichen Koinzidenz des vorbestimmten Datenmusters mit dem vor-bestimmten nicht korrigierbaren Fehlersyndrom (sf) als ein Systemsteuersignal (FLAG), und

Verhindern der Abgabe des nicht-korrigierbaren Fehlersignals im Fall einer solchen Koinzidenz.

7. Verfahren nach Anspruch 6, bei dem das vorbestimmte Datenmuster nach dem Ausführen der Einzelfehler-Korrektur erkannt wird.

8. Verfahren nach Anspruch 6 oder 7, bei dem das Systemsteuersignal eine Kennzeichnungsbedingung im Datenstrom anzeigt.

**Revendications**

1. Système informatique avec moyen (9, 11) de recherche et de correction d'erreurs (ECC) utilisant des syndromes d'erreurs pour des combinaisons de bits d'information et de bits de contrôle d'ECC, et produisant des signaux (drapeaux) de commande de système quand apparaissent des syndromes (sf) prédéterminés pour des erreurs non corrigibles, caractérisé en ce que le système comprend:

un premier moyen (3) pour détecter au moins une configuration prédéterminée dans les bits d'information;

un second moyen (13) pour détecter en tant que signal (drapeau) de commande de système la présence de la configuration prédéterminée d'informations coïncidant avec l'existence d'au moins un des syndromes (sf) prédéterminés d'erreurs non corrigibles; et

un moyen (15) pour empêcher le moyen d'ECC d'émettre un signal d'erreur dans le cas de ladite coïncidence.

2. Système selon la revendication 1, comprenant en outre un premier moyen (21, 23, 25, 27) pour corriger les erreurs portant sur un seul bit avant que les bits d'information ne soient fournis au premier moyen de détection.

3. Système selon la revendication 1 ou 2, dans lequel des moyens (33) sont présents pour combiner logiquement le syndrome d'erreur des bits d'information avec le syndrome d'erreur prédéterminé extrait d'un moyen de mémorisation (35) pour actionner des seconds moyens (41, 59) pour corriger les erreurs portant sur un seul bit dans le cas où un signal (UE) d'erreur non corrigible est émis par les premiers moyens pour corriger les erreurs portant sur un seul bit.

4. Système selon l'une quelconque des revendications 1 à 3, dans lequel des moyens de mémorisation (55) sont présents pour la combinaison de données prédéterminée, dont la sortie est reliée à un comparateur (45) recevant aussi les bits d'information dont les erreurs portant sur un seul bit sont corrigées.

5. Système selon l'une quelconque des revendications 1 à 4, dans lequel la combinaison de la configuration prédéterminée d'informations et du syndrome d'erreur prédéterminé représente un drapeau délimitant une frontière dans la suite de bits d'information et d'ECC, indiqué par le signal de commande de système.

6. Procédé pour commander la circulation de données dans un système informatique qui réalise la détection et la correction d'erreurs (ECC) à l'aide de syndromes (12) d'erreurs pour des combinaisons de bits d'information et de bits de contrôle d'ECC, et dans lequel des syndromes (sf) prédéterminés d'erreurs non corrigibles servent à produire des signaux (drapeaux) de commande de système,
caractérisé en ce que le procédé comprend les opérations suivantes:

détection d'au moins une configuration prédéterminée dans les bits d'informations;

détection, en tant que signal (drapeau) de commande de système, de la coïncidence de la configuration prédéterminée d'informations avec le syndrome prédéterminé (sf) d'erreur non corrigible, et

interdiction, en cas de coïncidence, du signal d'état d'erreur non corrigible.

7. Procédé selon la revendication 6, dans lequel la configuration prédéterminée d'informations est détectée après l'exécution d'une correction d'erreur portant sur un seul bit.

8. Procédé selon la revendication 6 ou 7, dans lequel le signal de commande de système indique un état de drapeau dans la suite de données.

# FIG. 1

FIG. 2

EP 0 097 158 B1

# FIG. 3

TO SYSTEM

SBEL

SBE

UE

7 TO 72 DECODER

256 X 9 ROM

256 X 9 ROM

7 TO 72 DECODER

SBE'

SBEL'

UE'

sf

UE TO SYSTEM

FLAG SYNDROME DETECT

EP 0 097 158 B1